# EUROPEAN PATENT APPLICATION

(11) **EP 2 613 359 A2**
(43) Date of publication of application: **10.07.2013**
(21) Application number: 12005772.4
(22) Date of filing: 08.08.2012
(51) Int. Cl.: H01L 31/0224, H01L 31/075, H01L 31/076

(54) **Thin film solar cell**

(30) Priority: 09.01.2012 KR 20120002491
(71) Applicant: LG Electronics Inc., Youngdungpo-ku Seoul 150-721 (KR)
(72) Inventor: You, Dongjoo, Seocho-Gu 137-724 Seoul (KR); Lee, Sungeun, Seocho-Gu 137-724 Seoul (KR); Lee, Heonmin, Seocho-Gu 137-724 Seoul (KR); Kim, Sunho, Seocho-Gu 137-724 Seoul (KR); Lee, Seungyoon, Seocho-Gu 137-724 Seoul (KR)
(74) Representative: Katérle, Axel

(57) **Abstract**

A thin film solar cell includes a substrate, a first electrode positioned on the substrate, a second electrode which is separated from the first electrode, and at least one photoelectric conversion unit positioned between the first electrode and the second electrode. A photoelectric conversion unit positioned farthest from an incident surface of light among the at least one photoelectric conversion unit includes a plurality of first depressions.

## Description

This application claims priority to and the benefit of Korean Patent Application No. 10-2012-0002491 filed in the Korean Intellectual Property Office on January 9th, 2012, the entire contents of which are incorporated herein by reference.

### BACKGROUND

### Field of the Disclosure

Embodiments of the invention relate to a thin film solar cell.

### Description of the Related Art

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted.

A solar cell generally includes semiconductor parts, which respectively have different conductive types, for example, a p-type and an n-type, and thus form a p-n junction, and electrodes respectively connected to the semiconductor parts of the different conductive types.

When light is incident on the solar cell, a plurality of electron-hole pairs are produced in the semiconductor parts. The electron-hole pairs are separated into electrons and holes by the photovoltaic effect. The separated electrons move to the n-type semiconductor part, and the separated holes move to the p-type semiconductor part. Then, the electrons and the holes are collected by the electrodes electrically connected to the n-type semiconductor part and the p-type semiconductor part, respectively. The electrodes are connected to each other using electric wires to thereby obtain electric power.

### SUMMARY

In one aspect, there is a thin film solar cell including a substrate, a first electrode positioned on the substrate, a second electrode which is separated from the first electrode, and at least one photoelectric conversion unit positioned between the first electrode and the second electrode, wherein a photoelectric conversion unit positioned farthest from an incident surface of light among the at least one photoelectric conversion unit includes a plurality of first depressions.

The photoelectric conversion unit positioned farthest from the incident surface of light may be positioned closest to the second electrode.

The plurality of first depressions may be formed in a direction proceeding from a surface of the photoelectric conversion unit adjacent to the second electrode and proceeding to the first electrode.

A depth of each of the plurality of first depressions may be about 20 % to 70 % of a thickness of an i-type semiconductor layer of the photoelectric conversion unit closest to the second electrode.

For example, the depth of each of the plurality of first depressions may be about 0.7 µm to 2.5 µm.

A distance between the first depressions may be greater than a width of each of the plurality of first depressions. For example, the width of each of the plurality of first depressions may be about 20 µm to 200 µm, and the distance between the first depressions may be about 0.5 mm to 2 mm.

An i-type semiconductor layer of the photoelectric conversion unit closest to the second electrode may have an uneven surface including a plurality of second depressions. A depth of each of the plurality of second depressions may be less than the depth of each of the plurality of first depressions.

A width of each of the plurality of second depressions may be less than the width of each of the plurality of first depressions. A tilt angle of each of the plurality of second depressions may be less than a tilt angle of each of the plurality of first depressions.

The plurality of second depressions may be formed in a direction proceeding from a surface of the photoelectric conversion unit adjacent to the second electrode and proceeding to the first electrode. The plurality of second depressions may be positioned between the plurality of first depressions and may not be formed on inner surfaces of the plurality of first depressions.

The photoelectric conversion unit closest to the second electrode may include a p-type semiconductor layer, an i-type semiconductor layer, and an n-type semiconductor layer which are sequentially stacked in a direction proceeding from the first electrode to the second electrode in the order named. The n-type semiconductor layer of the photoelectric conversion unit closest to the second electrode may be positioned on inner surfaces of the first depressions of the i-type semiconductor layer of the photoelectric conversion unit closest to the second electrode and on a surface of the i-type semiconductor layer between the first depressions.

A thickness of the n-type semiconductor layer positioned on the inner surfaces of the first depressions may be substantially equal to a thickness of the n-type semiconductor layer positioned on the surface of the i-type semiconductor layer between the first depressions.

The second electrode may include a plurality of protrusions protruding to the inside of the first depressions. A thickness of the second electrode positioned on the surface of the i-type semiconductor layer between the first depressions may be less than a width of each of the plurality of protrusions.

The at least one photoelectric conversion unit may include a first photoelectric conversion unit and a second photoelectric conversion unit which are sequentially positioned on the first electrode. An i-type semiconductor layer of the second photoelectric conversion unit may include the plurality of first depressions. The at least one photoelectric conversion unit may include a first photoelectric conversion unit, a second photoelectric conversion unit, and a third photoelectric conversion unit which are sequentially positioned on the first electrode. An i-type semiconductor layer of the third photoelectric conversion unit may include the plurality of first depressions. An i-type semiconductor layer of the at least one photoelectric conversion unit is formed of microcrystalline silicon.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:

FIG. 1 illustrates a thin film solar cell including a photoelectric conversion unit having a single junction structure according to an exemplary embodiment of the invention;

FIG. 2 illustrates a thin film solar cell including a photoelectric conversion unit having a double junction structure or a pin-pin structure according to an exemplary embodiment of the invention;

FIG. 3 illustrates a thin film solar cell including a photoelectric conversion unit having a triple junction structure or a pin-pin-pin structure according to an exemplary embodiment of the invention;

FIG. 4 is a graph illustrating a short circuit current of a triple junction thin film solar cell; and

FIGS. 5A to 5D illustrate a method for manufacturing a thin film solar cell according to an exemplary embodiment of the invention.

### DETAILED DESCRIPTION OF THE EMBODIMENTS

Reference will now be made in detail to embodiments of the invention, examples of which are illustrated in the accompanying drawings. This invention may, however, be embodied in many different forms and should not be construed as limited to the embodiments set forth herein. Wherever possible, the same reference numbers may be used throughout the drawings to refer to the same or like parts. It will be understood that detailed description of known arts may be omitted if it is determined that the arts do not aid in the understanding of the embodiments of the invention.

In the drawings, the thickness of layers, films, panels, regions, etc., may be exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on other element, it may be on the entire surface of the other element and may not be on a portion of an edge of the other element.

A thin film solar cell according to an embodiment of the invention includes a substrate, a first electrode positioned on the substrate, a second electrode which is separated from the first electrode and is positioned on the first electrode, and at least one photoelectric conversion unit positioned between the first electrode and the second electrode, the at least one photoelectric conversion unit including a plurality of depressions at its surface abutting on the second electrode.

The photoelectric conversion unit may have one structure or a plurality of structures each including a p-type semiconductor layer, an intrinsic (called i-type) semiconductor layer, and an n-type semiconductor layer.

The photoelectric conversion unit, which is positioned farthest from an incident surface of light, includes a plurality of first depressions.

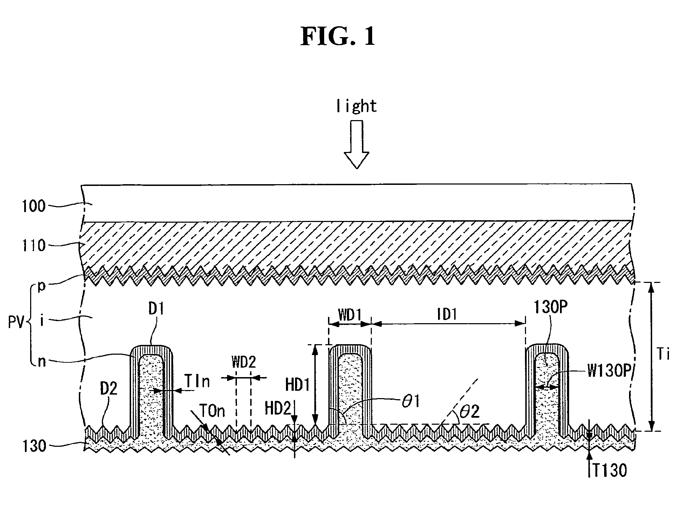

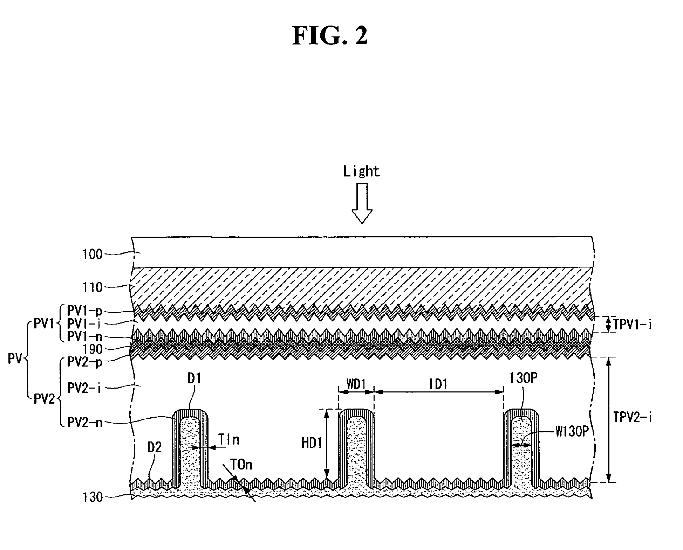

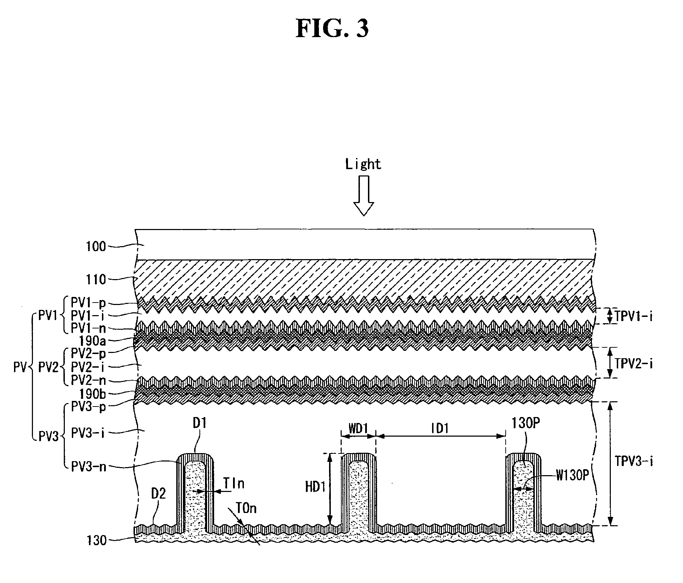

In the embodiment of the invention, FIG. 1 shows the thin film solar cell including one photoelectric conversion unit, FIG. 2 shows the thin film solar cell including two photoelectric conversion units, and FIG. 3 shows the thin film solar cell including three photoelectric conversion units. Further, FIGS. 1 to 3 show an operation of the first depressions based on the photoelectric conversion units each having a different structure.

FIG. 1 illustrates a thin film solar cell including a photoelectric conversion unit having a single junction structure according to an exemplary embodiment of the invention.

As shown in FIG. 1, the thin film solar cell according to the embodiment of the invention includes a substrate 100, a first electrode 110, a photoelectric conversion unit PV, and a second electrode 130. The photoelectric conversion unit PV includes a plurality of first depressions D1.

More specifically, FIG. 1 illustrates the photoelectric conversion unit PV having a pin structure from an incident surface of the substrate 100. Alternatively, the photoelectric conversion unit PV may have an nip structure from the incident surface of the substrate 100. In the following description, the photoelectric conversion unit PV having the pin structure from the incident surface of the substrate 100 is taken as an example for the sake of brevity.

The substrate 100 may be formed of a substantially transparent non-conductive material, for example, glass or plastic, so that light incident on the substrate 100 efficiently reaches the photoelectric conversion unit PV.

Light is incident on the incident surface (or a first surface) of the substrate 100, and the first electrode 110 is positioned on a second surface opposite the incident surface of the substrate 100. In the following description, the first surface is a surface of the same direction as the surface of the substrate 100, on which the first electrode 110 is not positioned. Further, the second surface is a surface of the same direction as the surface of the substrate 100, on which the first electrode 110 is positioned.

The first electrode 110 is positioned on the second surface of the substrate 100 and contains a conductive material capable of transmitting light so as to increase a transmittance of incident light.

The conductive material of the first electrode 110 has a high transmittance and high electrical conductivity. For example, the first electrode 110 may contain at least one of indium tin oxide (ITO), tin-based oxide (for example, SnO₂), AgO, ZnO-Ga₂O₃ (or ZnO-Al₂O₃), fluorine tin oxide (FTO), boron-doped zinc oxide (ZnO:B or BZO), and aluminum-doped zinc oxide (ZnO:Al or AZO).

The photoelectric conversion unit PV is positioned on a second surface of the first electrode 110. The first electrode 110 may be electrically connected to the photoelectric conversion unit PV. Hence, the first electrode 110 may collect carriers (for example, holes) produced by light incident on the substrate 100 and may output the collected carriers.

A plurality of uneven portions may be formed on the second surface of the first electrode 110. In other words, the first electrode 110 may have a textured surface including the plurality of uneven portions.

When the surface of the first electrode 110 is textured, the first electrode 110 may reduce a reflectance of incident light and increase an absorptance of the incident light. Hence, the efficiency of the thin film solar cell may be improved.

The second electrode 130 is positioned on the photoelectric conversion unit PV to be separated from the second surface of the first electrode 110. The second electrode 130 may be formed of a metal material with high electrical conductivity so as to increase a recovery efficiency of electric power generated by the photoelectric conversion unit PV.

The second electrode 130 may be electrically connected to the photoelectric conversion unit PV. The second electrode 130 may collect carriers (for example, electrons) produced by incident light and may output the collected carriers.

The photoelectric conversion unit PV is positioned between the first electrode 110 and the second electrode 130. The photoelectric conversion unit PV converts light incident on the incident surface of the substrate 100 from the outside into electricity.

The photoelectric conversion unit PV may have a pin structure including a p-type semiconductor layer 'p', an intrinsic (called i-type) semiconductor layer 'i', and an n-type semiconductor layer 'n' that are sequentially stacked on the second surface of the first electrode 110 in the order named. Other layers may be included or present in the photoelectric conversion unit PV or therebetween.

The p-type semiconductor layer 'p' is positioned on the second surface of the first electrode 110. The p-type semiconductor layer 'p' may be formed using a gas obtained by adding impurities of a group III element, such as boron (B), gallium (Ga), and indium (In), to a raw gas containing silicon (Si).

The i-type semiconductor layer 'i' is positioned on a second surface of the p-type semiconductor layer 'p'. The i-type semiconductor layer 'i' may prevent or reduce a recombination of carriers and may absorb light. The i-type semiconductor layer 'i' may absorb incident light to produce carriers such as electrons and holes.

The i-type semiconductor layer 'i' may contain amorphous silicon (a-si) or microcrystalline silicon (µc-Si).

The n-type semiconductor layer 'n' is positioned on a second surface of the i-type semiconductor layer 'i'. The n-type semiconductor layer 'n' may be formed using a gas obtained by adding impurities of a group V element, such as phosphorus (P), arsenic (As), and antimony (Sb), to a raw gas containing silicon (Si).

The photoelectric conversion unit PV may be formed using a chemical vapor deposition (CVD) method, such as a plasma enhanced CVD (PECVD) method.

As shown in FIG. 1, doped layers of the photoelectric conversion unit PV, for example, the p-type semiconductor layer 'p' and the n-type semiconductor layer 'n' may form a p-n junction with the i-type semiconductor layer 'i' interposed between the doped layers 'p' and 'n'.

In such a structure of the photoelectric conversion unit PV, when light is incident on the p-type semiconductor layer 'p', a depletion region is formed inside the i-type semiconductor layer 'i' due to the p-type semiconductor layer 'p' and the n-type semiconductor layer 'n' each having a relatively high doping concentration, thereby generating an electric field. Electrons and holes produced in the i-type semiconductor layer 'i' corresponding to a light absorbing layer are separated from each other by a contact potential difference and move in different directions.

For example, the holes may move to the first electrode 110 through the p-type semiconductor layer 'p', and the electrons may move to the second electrode 130 through the n-type semiconductor layer 'n', Hence, the electric power may be produced.

As shown in FIG. 1, when the thin film solar cell includes one photoelectric conversion unit PV, the plurality of first depressions D1 are formed on a portion of the photoelectric conversion unit positioned farthest from the incident surface of light, i.e., the second surface of the i-type semiconductor layer 'i' positioned close to the second electrode 130.

Unlike the configuration shown in FIG. 1, when light passes through the second electrode 130 and then is incident on one photoelectric conversion unit PV, the plurality of first depressions D1 may be formed on a portion of the photoelectric conversion unit positioned farthest from the incident surface of light, i.e., a first surface of the i-type semiconductor layer 'i' positioned closest to the first electrode 110.

In the following description, the case where light passes through the first electrode 110 and then is incident on the photoelectric conversion unit PV as shown in FIG. 1 is taken as an example for the sake of brevity.

The plurality of first depressions D1 may be depressed in a direction proceeding from the second surface of the i-type semiconductor layer 'i' adjacent to the second electrode 130 and proceeding to the first electrode 110.

The n-type semiconductor layer 'n' is positioned on the second surface of the i-type semiconductor layer 'i'. Further, the n-type semiconductor layer 'n' may be positioned on inner surfaces of the first depressions D1 of the i-type semiconductor layer 'i' and on an outer surface between the first depressions D1. The second electrode 130 is positioned on a second surface of the n-type semiconductor layer 'n'. Further, the second electrode 130 may include a plurality of protrusions 130p protruding to the inside of the first depressions D1 of the i-type semiconductor layer 'i'.

The thin film solar cell having the above-described structure may shorten a moving distance of carriers (for example, electrons or holes) produced in the i-type semiconductor layer 'i', thereby further improving a short circuit current. Hence, photoelectric conversion efficiency of the thin film solar cell may be further improved.

However, if the i-type semiconductor layer 'i' does not include the first depressions D1, a moving distance (from the i-type semiconductor layer 'i' to the n-type semiconductor layer 'n') of carriers produced in the i-type semiconductor layer 'i' may relatively increase.

In this instance, a disappearance possibility of carriers produced in the i-type semiconductor layer 'i' may relatively increase on the way from the i-type semiconductor layer 'i' to the n-type semiconductor layer 'n' because of a short life time of carriers and a defect of the i-type semiconductor layer 'i'.

The disappearance of carriers may cause a reduction in the photoelectric conversion efficiency of the thin film solar cell.

On the other hand, in the embodiment of the invention, because the i-type semiconductor layer 'i' includes the plurality of first depressions D1 and the n-type semiconductor layer 'n' is formed on the inner surfaces of the first depressions D1, the moving distance of carriers may be shortened. The disappearance possibility of carriers produced in the i-type semiconductor layer 'i' on the way from the i-type semiconductor layer 'i' to the n-type semiconductor layer 'n' may be greatly reduced. Thus, the photoelectric conversion efficiency of the thin film solar cell may be further improved.

The effect of the thin film solar cell may be more efficiently obtained when the i-type semiconductor layer 'i' is formed of microcrystalline silicon.

More specifically, when the i-type semiconductor layer 'i' is formed of microcrystalline silicon, a crystal structure included in microcrystalline silicon has a columnar structure elongating in a direction vertical to the substrate 100.

When a thickness Ti of the i-type semiconductor layer 'i' formed of microcrystalline silicon is equal to or less than about 1 µm, the columnar crystal structure of the i-type semiconductor layer 'i' does not particularly cause a defect. However, as the thickness Ti of the i-type semiconductor layer 'i' increases so as to absorb light of a long wavelength band, the defect may be generated at a boundary, at which the columnar crystal structures meet one another.

Accordingly, an amount of carriers disappeared by the defect generated at the boundary, at which the columnar crystal structures meet one another, may increase.

As a result, when the thickness Ti of the i-type semiconductor layer 'i' increases so as to increase the short circuit current, the short circuit current may not increase but decrease because of the defect between the columnar crystal structures.

On the other hand, in the embodiment of the invention, because the i-type semiconductor layer 'i' includes the plurality of first depressions D1, the moving distance of carriers does not greatly increase due to the first depressions D1 even if the thickness Ti of the i-type semiconductor layer 'i' greatly increases so as to absorb light of the long wavelength band. Thus, because carriers move a relatively short distance inside the i-type semiconductor layer 'i', the disappearance of carriers resulting from the defect may be prevented or reduced. Hence, the short circuit current may increase.

In other words, carriers produced in a portion of the i-type semiconductor layer 'i' relatively close to the p-type semiconductor layer 'p' move to the n-type semiconductor layer 'n' formed on inner bottom surfaces of the first depressions D1. Hence, the moving distance of carriers may be shortened. Further, carriers produced in a portion of the i-type semiconductor layer 'i' relatively far from the p-type semiconductor layer 'p' move to the n-type semiconductor layer 'n' formed on inner sides of the first depressions D1 or the outer surface between the first depressions D1. Hence, the moving distance of carriers may be shortened.

The structure of the i-type semiconductor layer 'i' including the plurality of first depressions D1 may be more efficiently applied to a double or triple junction thin film solar cell absorbing both light of a short wavelength band and light of a long wavelength band than the single junction thin film solar cell including the photoelectric conversion unit PV having one pin structure.

The double junction thin film solar cell and the triple junction thin film solar cell will be described in detail later with reference to FIGS. 2 and 3.

The structure of the first depression D1 of the i-type semiconductor layer 'i' is described in detail below.

A depth HD1 of the first depression D1 may be about 20 % to 70 % of the thickness Ti of the i-type semiconductor layer 'i'.

When the depth HD1 of the first depression D1 is equal to or greater than about 20 % of the thickness Ti of the i-type semiconductor layer 'i', the short circuit current may be increased at a minimum level. When the depth HD1 of the first depression D1 is equal to or less than about 70 % of the thickness Ti of the i-type semiconductor layer 'i', this is make the moving distance of carriers to be more shorter and the short circuit current may be increased at a sufficient level, and the minimum thickness (from the bottom of the first depression D1 to a first surface of the i-type semiconductor layer 'i', herein the first surface of the i-type semiconductor layer 'i' is contacted with the p-type semiconductor layer 'p') of the i-type semiconductor layer 'i' capable of absorbing light may be secured. Hence, a minimum absorption amount of light may be secured.

In other words, the depth HD1 of the first depression D1 may be determined depending on the thickness Ti of the i-type semiconductor layer 'i'. For example, when the thickness Ti of the i-type semiconductor layer 'i' is about 3.5 µm, the depth HD1 of the first depression D1 may be about 0.7 µm to 2.5 µm.

A distance ID1 between the first depressions D1 may be greater than a width WD1 of each first depression D1.

As described above, when the distance ID1 between the first depressions D1 is greater than the width WD1 of the first depression D1, an area of the i-type semiconductor layer 'i' capable of absorbing light may be properly secured.

When the distance ID1 between the first depressions D1 is less than the width WD1 of the first depression D1, a reduction in the distance ID1 between the first depressions D1 may show the same characteristic as a reduction in the thickness Ti of the i-type semiconductor layer 'i'. In this instance, the absorptance of light of the long wavelength band may be reduced.

In the embodiment of the invention, the distance ID1 between the first depressions D1 may be properly determined to be about 0.5 mm to 2 mm, and the width WD1 of the first depression D1 may be properly determined to be about 20 µm to 200 µm.

A difference between the first depressions D1 formed on the second surface of the i-type semiconductor layer 'i' and a plurality of uneven portions formed on the second surface of the i-type semiconductor layer 'i' is described below.

As shown in FIG. 1, the second surface of the first electrode 110 may have the plurality of uneven portions, so as to scatter light incident on the substrate 100 and to minimize the reflection of light. The plurality of uneven portions of the first electrode 110 have a plurality of protrusions and a plurality of depressions.

The shape of the uneven portions of the first electrode 110 may affect the second surface of the i-type semiconductor layer 'i' because the entire thickness of the photoelectric conversion unit PV is relatively thin.

Thus, the second surface of the i-type semiconductor layer 'i' may include a plurality of uneven portions having a plurality of second depressions D2 which are different from the first depressions D1 in the shape and the function.

More specifically, the first depressions D1 are formed to reduce the moving distance of carriers produced in the i-type semiconductor layer 'i'. The second depressions D2 are formed based on the shape of the uneven portions of the first electrode 110. Further, the second depressions D2 scarcely contributes to the improvement of the efficiency of the thin film solar cell because the scattering of light and the anti-reflection of light are not necessary in the second surface of the i-type semiconductor layer 'i'.

Further, the shape of the second depressions D2 formed on the second surface of the i-type semiconductor layer 'i' has a gradual slope, because the shape of the uneven portions of the first electrode 110 has a gradual slope by the p-type semiconductor layer 'p' deposited on the second surface of the first electrode 110 and the thickness Ti of the i-type semiconductor layer 'i'.

Thus, a width, a depth, and a tilt angle of each of the second depressions D2 of the i-type semiconductor layer 'i' may be less than a width, a depth, and a tilt angle of each of the depressions included in the uneven portions of the first electrode 110, respectively.

More specifically, as shown in FIG. 1, the second depressions D2 are depressed in a direction proceeding from the second surface of the i-type semiconductor layer 'i' adjacent to the second electrode 130 and proceeding to the first electrode 110. A depth HD2 of the second depression D2 may be less than the depth HD1 of the first depression D1, and a width WD2 of the second depression D2 may be less than the width WD1 of the first depression D1. Further, a tilt angle θ2 of the second depression D2 may be less than a tilt angle θ1 of the first depression D1.

The plurality of uneven portions including the second depressions D2 are formed in a portion (i.e., the outer surface between the first depressions D1) of the second surface of the i-type semiconductor layer 'i', in which the first depressions D1 are not formed, because of characteristics of a method for manufacturing the thin film solar cell. The plurality of uneven portions including the second depressions D2 may not be formed on inner surfaces of the first depressions D1.

When the thickness of the photoelectric conversion unit PV in the double junction thin film solar cell and the triple junction thin film solar cell increases, the difference between the shapes of the first depressions D1 and the second depressions D2 may more clearly appear.

Namely, in the double junction thin film solar cell and the triple junction thin film solar cell each including a plurality of photoelectric conversion units, the second depressions D2 may not be formed on a second surface of an i-type semiconductor layer 'i' of a photoelectric conversion unit closest to the second electrode 130 among the plurality of photoelectric conversion units. Alternatively, even if the second depressions D2 are formed, a depth and a tilt angle of each of the second depressions D2 may be very small.

The n-type semiconductor layer 'n' positioned on the i-type semiconductor layer 'i' is positioned on the inner surfaces of the first depressions D1 of the i-type semiconductor layer 'i' and on the outer surface between the first depressions D1.

As described above, the n-type semiconductor layer 'n' may form the p-n junction along with the p-type semiconductor layer 'p' with the i-type semiconductor layer 'i' interposed between the doped layers 'p' and 'n'. The n-type semiconductor layer 'n' may be formed using the deposition method such as the PECVD method.

A thickness TIn of the n-type semiconductor layer 'n' positioned on the inner surfaces of the first depressions D1 may be substantially equal to a thickness TOn of the n-type semiconductor layer 'n' positioned on the outer surface between the first depressions D1 within an error tolerance.

In other words, when the n-type semiconductor layer 'n' is formed on the inner surfaces of the first depressions D1 of the i-type semiconductor layer 'i' and on the outer surface between the first depressions D1 using the deposition method such as the PECVD method, the thickness of the n-type semiconductor layer 'n' may relatively increase at an edge, at which the inner surfaces of the first depressions D1 meet the outer surface between the first depressions D1, because of the properties of the PECVD method. However, the thickness of the n-type semiconductor layer 'n' at the edge is within the error tolerance. Further, the thickness TIn and the thickness TOn of the n-type semiconductor layer 'n' positioned on the inner surfaces of the first depressions D1 and on the outer surface between the first depressions D1 may be substantially equal to each other.

The second electrode 130 positioned on the second surface of the n-type semiconductor layer 'n' may include the plurality of protrusions 130p protruding to the inside of the first depressions D1 of the i-type semiconductor layer 'i'.

The second electrode 130 is configured so that carriers moving to the n-type semiconductor layer 'n' positioned on the inner surfaces of the first depressions D1 of the i-type semiconductor layer 'i' move to a junction box (i.e., an external circuit controlling the electric power) through the second electrode 130 formed of the metal material with the electrical conductivity without a loss.

As shown in FIG. 1, a thickness T130 of the second electrode 130 positioned on the outer surface between the first depressions D1 may be less than a width W130P of the protrusion 130p positioned on the inner surface of the first depression D1.

Alternatively, the thickness T130 of the second electrode 130 positioned on the outer surface between the first depressions D1 may be substantially equal to or greater than the width W130P of the protrusion 130p.

So far, the embodiment of the invention described the single junction thin film solar cell. However, the embodiment of the invention may be equally applied to the double junction thin film solar cell and the triple junction thin film solar cell.

FIG. 2 illustrates a thin film solar cell including a photoelectric conversion unit having a double junction structure or a pin-pin structure according to an exemplary embodiment of the invention.

Structures and components identical or equivalent to those described above may be designated with the same reference numerals, and a further description may be briefly made or may be entirely omitted.

As shown in FIG. 2, a photoelectric conversion unit PV of the double junction thin film solar cell according to the embodiment of the invention may include a first photoelectric conversion unit PV1 and a second photoelectric conversion unit PV2 which are sequentially positioned on a first electrode 110 in the order named. In this instance, the second photoelectric conversion unit PV2 is positioned closer to a second electrode 130 than the first photoelectric conversion unit PV1.

In the double junction thin film solar cell shown in FIG. 2, a first p-type semiconductor layer PV1-p, a first i-type semiconductor layer PV1-i, a first n-type semiconductor layer PV1-n, a second p-type semiconductor layer PV2-p, a second i-type semiconductor layer PV2-i, and a second n-type semiconductor layer PV2-n may be sequentially stacked on an incident surface of the substrate 100 in the order named. Other layers may be included or present in the first and/or second photoelectric conversion units or therebetween.

An interlayer may be positioned between the first photoelectric conversion unit PV1 and the second photoelectric conversion unit PV2. In other words, an interlayer 190 may be positioned between the first n-type semiconductor layer PV1-n and the second p-type semiconductor layer PV2-p. The interlayer 190 may be omitted, if desired.

The first i-type semiconductor layer PV1-i may mainly absorb light of a short wavelength band to produce electrons and holes.

The second i-type semiconductor layer PV2-i may mainly absorb light of a long wavelength band wider than the short wavelength band to produce electrons and holes. For this, a thickness TPV2-i of the second i-type semiconductor layer PV2-i may be greater than a thickness TPV1-i of the first i-type semiconductor layer PV1-i.

For example, if the thickness TPV1-i of the first i-type semiconductor layer PV1-i is about 100 nm to 150 nm, the thickness TPV2-i of the second i-type semiconductor layer PV2-i may be about 1.5 µm to 4 µm.

As described above, because the double junction thin film solar cell absorbs light of the short wavelength band and light of the long wavelength band to produce carriers, the efficiency of the double junction thin film solar cell may be improved.

In the double junction thin film solar cell shown in FIG. 2, the first i-type semiconductor layer PV1-i of the first photoelectric conversion unit PV1 may contain amorphous silicon (a-Si), and the second i-type semiconductor layer PV2-i of the second photoelectric conversion unit PV2 may contain germanium-containing microcrystalline silicon (µc-SiGe).

The second i-type semiconductor layer PV2-i of the second photoelectric conversion unit PV2 closest to the second electrode 130 among the photoelectric conversion units PV1 and PV2 includes a plurality of depressions D1 on its second surface.

In the double junction thin film solar cell shown in FIG. 2, a depth HD1 and a width WD1 of each of the first depressions D1, and a distance ID1 between the first depressions D1 may be determined in the same manner as the single junction thin film solar cell shown in FIG. 1.

Thus, the depth HD1 of each depression D1 may be about 20 % to 70 % of the thickness TPV2-i of the second i-type semiconductor layer PV2-i. For example, the depth HD1 of the first depression D1 may be about 0.7 µm to 2.5 µm. Further, the distance ID1 between the first depressions D1 may be properly determined to be about 0.5 mm to 2 mm, and the width WD1 of the first depression D1 may be properly determined to be about 20 µm to 200 µm.

The second n-type semiconductor layer PV2-n is positioned on the second i-type semiconductor layer PV2-i. More specifically, the second n-type semiconductor layer PV2-n is positioned on inner surfaces of the first depressions D1 of the second i-type semiconductor layer PV2-i and on an outer surface between the first depressions D1. A thickness TIn of the second n-type semiconductor layer PV2-n positioned on the inner surfaces of the first depressions D1 may be substantially equal to a thickness TOn of the second n-type semiconductor layer PV2-n positioned on the outer surface between the first depressions D1 within an error tolerance.

The second electrode 130 may include a plurality of protrusions 130p protruding to the inside of the first depressions D1 of the second i-type semiconductor layer PV2-i.

As described above, the double junction thin film solar cell according to the embodiment of the invention includes the plurality of first depressions D1 on the second surface of the second i-type semiconductor layer PV2-i of the second photoelectric conversion unit PV2, thereby reducing a moving distance of carriers inside the second i-type semiconductor layer PV2-i even if a defect is generated inside the second i-type semiconductor layer PV2-i because of the relatively thickness of the second i-type semiconductor layer PV2-i. Hence, the disappearance of carriers resulting from the defect of the second i-type semiconductor layer PV2-i may be prevented or reduced. As a result, the short circuit current may increase, and the photoelectric conversion efficiency of the double junction thin film solar cell may be further improved.

FIG. 3 illustrates a thin film solar cell including a photoelectric conversion unit having a triple junction structure or a pin-pin-pin structure according to an exemplary embodiment of the invention.

Structures and components identical or equivalent to those described above may be designated with the same reference numerals, and a further description may be briefly made or may be entirely omitted.

As shown in FIG. 3, a photoelectric conversion unit PV of the triple junction thin film solar cell according to the embodiment of the invention may include a first photoelectric conversion unit PV1, a second photoelectric conversion unit PV2, and a third photoelectric conversion unit PV3 which are sequentially positioned on a first electrode 110 in the order named.

In the triple junction thin film solar cell shown in FIG. 3, each of the first photoelectric conversion unit PV1, the second photoelectric conversion unit PV2, and the third photoelectric conversion unit PV3 may have the pin structure. Thus, a first p-type semiconductor layer PV1-p, a first i-type semiconductor layer PV1-i, a first n-type semiconductor layer PV1-n, a second p-type semiconductor layer PV2-p, a second i-type semiconductor layer PV2-i, a second n-type semiconductor layer PV2-n, a third p-type semiconductor layer PV3-p, a third i-type semiconductor layer PV3-i, and a third n-type semiconductor layer PV3-n may be sequentially positioned on a substrate 100 in the order named. Other layers may be included or present in the first, second, and/or third photoelectric conversion units or therebetween.

A first interlayer 190a may be positioned between the first photoelectric conversion unit PV1 and the second photoelectric conversion unit PV2, and a second interlayer 190b may be positioned between the second photoelectric conversion unit PV2 and the third photoelectric conversion unit PV3. The first interlayer 190a and the second interlayer 190b may be omitted.

The first i-type semiconductor layer PV1-i, the second i-type semiconductor layer PV2-i, and the third i-type semiconductor layer PV3-i may be variously implemented.

As a first example of the configuration illustrated in FIG. 3, the first i-type semiconductor layer PV1-i may contain amorphous silicon (a-Si), the second i-type semiconductor layer PV2-i may contain germanium-containing amorphous silicon (a-SiGe), and the third i-type semiconductor layer PV3-i may contain germanium-containing microcrystalline silicon (µc-SiGe). Alternatively, the second i-type semiconductor layer PV2-i and the third i-type semiconductor layer PV3-i may be doped with impurities of germanium (Ge).

An amount of germanium (Ge) contained in the third i-type semiconductor layer PV3-i may be more than an amount of germanium (Ge) contained in the second i-type semiconductor layer PV2-i. Because an energy band gap decreases as the amount of germanium (Ge) increases, a component having a small energy band gap is advantageous in absorbing light of a long wavelength band.

Accordingly, when the amount of germanium (Ge) contained in the third i-type semiconductor layer PV3-i is more than the amount of germanium (Ge) contained in the second i-type semiconductor layer PV2-i, the third i-type semiconductor layer PV3-i may more efficiently absorb light of the long wavelength band.

Alternatively, as a second example of the configuration illustrated in FIG. 3, the first i-type semiconductor layer PV1-i may contain amorphous silicon (a-Si), and the second i-type semiconductor layer PV2-i and the third i-type semiconductor layer PV3-i may contain microcrystalline silicon (µc-Si). Only the third i-type semiconductor layer PV3-i may be doped with impurities of germanium (Ge), and thus the energy band gap of the third i-type semiconductor layer PV3-i may be reduced.

The first photoelectric conversion unit PV1 may absorb light of a short wavelength band to produce electric power. The second photoelectric conversion unit PV2 may absorb light of a middle wavelength band between the short wavelength band and the long wavelength band to produce electric power. The third photoelectric conversion unit PV3 may absorb light of the long wavelength band to produce electric power.

For this, a thickness TPV3-i of the third i-type semiconductor layer PV3-i may be greater than a thickness TPV2-i of the second i-type semiconductor layer PV2-i, and the thickness TPV2-i of the second i-type semiconductor layer PV2-i may be greater than a thickness TPV1-i of the first i-type semiconductor layer PV1-i.

For example, the thickness TPV1-i of the first i-type semiconductor layer PV1-i may be about 100 nm to 150 nm, the thickness TPV2-i of the second i-type semiconductor layer PV2-i may be about 150 nm to 300 nm, and the thickness TPV3-i of the third i-type semiconductor layer PV3-i may be about 1.5 µm to 4 µm.

The thicknesses may be determined so as to further increase an absorptance of the third i-type semiconductor layer PV3-i with respect to the light of the long wavelength band.

The triple junction thin film solar cell shown in FIG. 3 may absorb light of the wider band and thus may further increase the production efficiency of electric power.

The third i-type semiconductor layer PV3-i of the third photoelectric conversion unit PV3 closest to a second electrode 130 among the photoelectric conversion units PV1, PV2, and PV3 includes a plurality of depressions D1 on its second surface in the same manner as FIGS. 1 and 2.

In the triple junction thin film solar cell shown in FIG. 3, a depth HD1 and a width WD1 of each of the first depressions D1, and a distance ID1 between the first depressions D1 may be determined in the same manner as the single junction thin film solar cell shown in FIG. 1.

Thus, the depth HD1 of each depression D1 may be about 20 % to 70 % of the thickness TPV3-i of the third i-type semiconductor layer PV3-i. For example, the depth HD1 of the first depression D1 may be about 0.7 µm to 2.5 µm. Further, the distance ID1 between the first depressions D1 may be properly determined to be about 0.5 mm to 2 mm, and the width WD1 of the first depression D1 may be properly determined to be about 20 µm to 200 µm.

The third n-type semiconductor layer PV3-n is positioned on the third i-type semiconductor layer PV3-i. More specifically, the third n-type semiconductor layer PV3-n is positioned on inner surfaces of the first depressions D1 of the third i-type semiconductor layer PV3-i and on an outer surface between the first depressions D1. A thickness TIn of the third n-type semiconductor layer PV3-n positioned on the inner surfaces of the first depressions D1 may be substantially equal to a thickness TOn of the third n-type semiconductor layer PV3-n positioned on the outer surface between the first depressions D1 within an error tolerance.

The second electrode 130 may include a plurality of protrusions 130p protruding to the inside of the first depressions D1 of the third i-type semiconductor layer PV3-i.

As described above, the triple junction thin film solar cell according to the embodiment of the invention includes the plurality of first depressions D1 on the second surface of the third i-type semiconductor layer PV3-i of the third photoelectric conversion unit PV3, thereby reducing a moving distance of carriers inside the third i-type semiconductor layer PV3-i even if a defect is generated inside the third i-type semiconductor layer PV3-i because of the relatively thick thickness of the third i-type semiconductor layer PV3-i. Hence, the disappearance of carriers resulting from the defect of the third i-type semiconductor layer PV3-i may be prevented or reduced. As a result, the short circuit current may increase, and the photoelectric conversion efficiency of the triple junction thin film solar cell may be further improved.

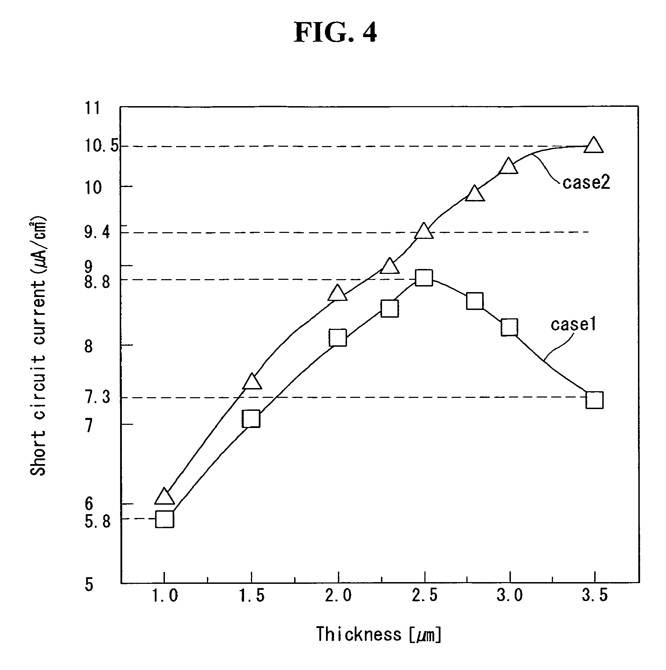

FIG. 4 is a graph illustrating the short circuit current of the triple junction thin film solar cell.

In FIG. 4, case 1 indicates the short circuit current of the thin film solar cell depending on the thickness TPV3-i of the third i-type semiconductor layer PV3-i when the third i-type semiconductor layer PV3-i of the third photoelectric conversion unit PV3 closest to the second electrode 130 among the photoelectric conversion units does not include the first depressions D1. Further, case 2 indicates the short circuit current of the thin film solar cell depending on the thickness TPV3-i of the third i-type semiconductor layer PV3-i when the third i-type semiconductor layer PV3-i of the third photoelectric conversion unit PV3 closest to the second electrode 130 among the photoelectric conversion units includes the plurality of first depressions D1.

As shown in FIG. 4, in the case 1 where the third i-type semiconductor layer PV3-i of the third photoelectric conversion unit PV3 closest to the second electrode 130 does not include the first depressions D1, when the thickness TPV3-i of the third i-type semiconductor layer PV3-i increased from about 1.0 µm to 2.5 µm, the short circuit current increased from about 5.8 mA/cm² to 8.8 mA/cm². On the other hand, when the thickness TPV3-i of the third i-type semiconductor layer PV3-i increased from about 2.5 µm to 3.5 µm, the short circuit current decreased from about 8.8 mA/cm² to 7.3 mA/cm².

As described above with reference to FIG. 1, as the thickness TPV3-i of the third i-type semiconductor layer PV3-i increases, the defect may increase at the boundary, at which the columnar crystal structures meet one another. When a production amount of carriers resulting from an increase in the thickness TPV3-i of the third i-type semiconductor layer PV3-i is more than a loss amount of carriers (resulting from the defect) moving inside the third i-type semiconductor layer PV3-i, the short circuit current may increase. However, when the thickness TPV3-i of the third i-type semiconductor layer PV3-i is greater than about 2.5 µm, a production amount of carriers resulting from an increase in the thickness TPV3-i of the third i-type semiconductor layer PV3-i is less than a loss amount of carriers resulting from the defect. Hence, the short circuit current may decrease.

On the other hand, the thin film solar cell according to the embodiment of the invention includes the plurality of first depressions D1 on the second surface of the third i-type semiconductor layer PV3-i of the third photoelectric conversion unit PV3, thereby greatly reducing the moving distance of carriers moving inside the third i-type semiconductor layer PV3-i. Hence, an amount of carriers disappeared by the defect may greatly decrease. For example, as shown in FIG. 4, in the thin film solar cell according to the embodiment of the invention (corresponding to the case 2), the short circuit current may continuously increase in proportion to the thickness TPV3-i of the third i-type semiconductor layer PV3-i. As a result, the efficiency of the thin film solar cell may be further improved.

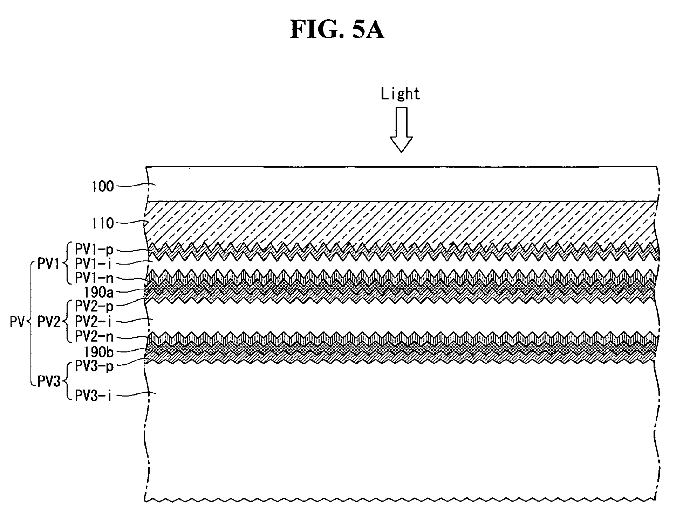

A method for manufacturing the thin film solar cell, in which the i-type semiconductor layer of the photoelectric conversion unit closest to the second electrode among the plurality of photoelectric conversion units includes the plurality of first depressions, is described below with reference to FIGS. 5A to 5D.

FIGS. 5A to 5D illustrate a method for manufacturing a thin film solar cell according to an exemplary embodiment of the invention.

As shown in FIG. 5A, a substrate 100, a first electrode 110, a first photoelectric conversion unit PV1, a first interlayer 190a, a second photoelectric conversion unit PV2, a second interlayer 190b, and a third p-type semiconductor layer PV3-p and a third i-type semiconductor layer PV3-i of a third photoelectric conversion unit PV3 are formed.

The first electrode 110 may be formed on the substrate 100 using various methods such as an electroplating method, a sputtering method, an evaporation method, and a low pressure chemical vapor deposition (LPCVD) method.

The first photoelectric conversion unit PV1, the first interlayer 190a, the second photoelectric conversion unit PV2, the second interlayer 190b, and the third p-type semiconductor layer PV3-p and the third i-type semiconductor layer PV3-i of the third photoelectric conversion unit PV3 may be formed using the CVD method, for example, the PECVD method.

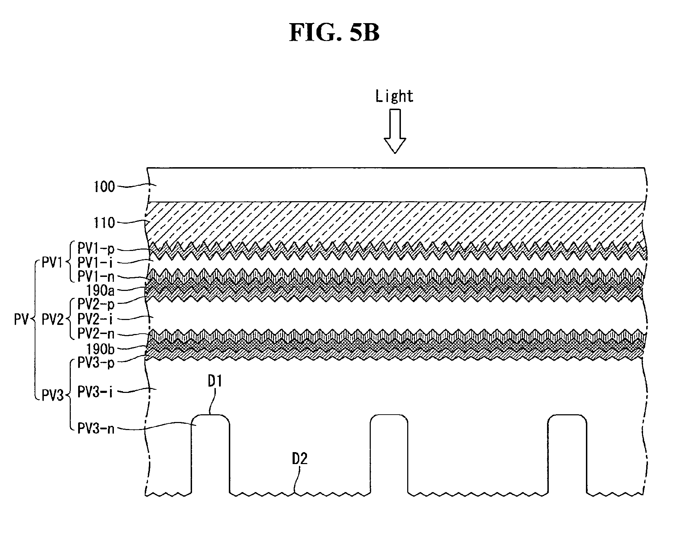

Next, as shown in FIG. 5B, a plurality of first depressions D1 of a pattern form are formed on a second surface of the third i-type semiconductor layer PV3-i using a scribing method or an etching method.

In the embodiment of the invention, the scribing method may use a mechanical scribing method or a laser scribing method.

Further, a photolithography method may be used as an example of the etching method.

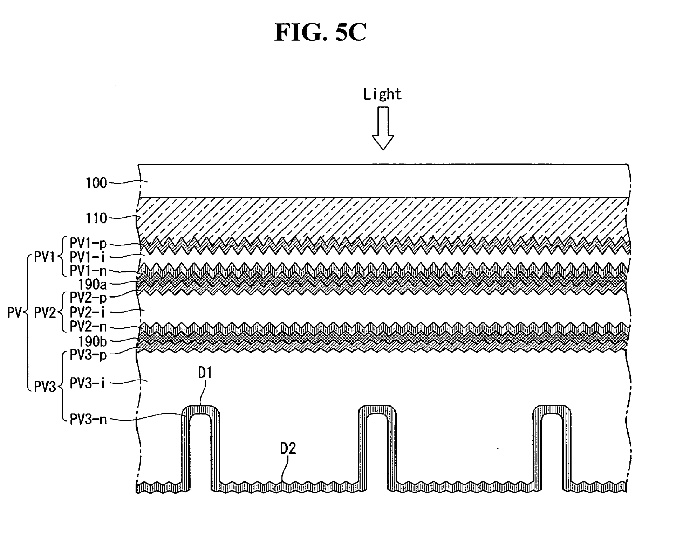

Next, as shown in FIG. 5C, a third n-type semiconductor layer PV3-n is formed on inner surfaces of the first depressions D1 of the third i-type semiconductor layer PV3-i and on an outer surface between the first depressions D1 using the PECVD method, etc.

In the embodiment of the invention, a thickness of the third n-type semiconductor layer PV3-n positioned on the inner surfaces of the first depressions D1 may be substantially equal to a thickness of the third n-type semiconductor layer PV3-n positioned on the outer surface between the first depressions D1 within an error tolerance.

The third p-type semiconductor layer PV3-p and the third n-type semiconductor layer PV3-n form a p-n junction with the third i-type semiconductor layer PV3-i interposed between them.

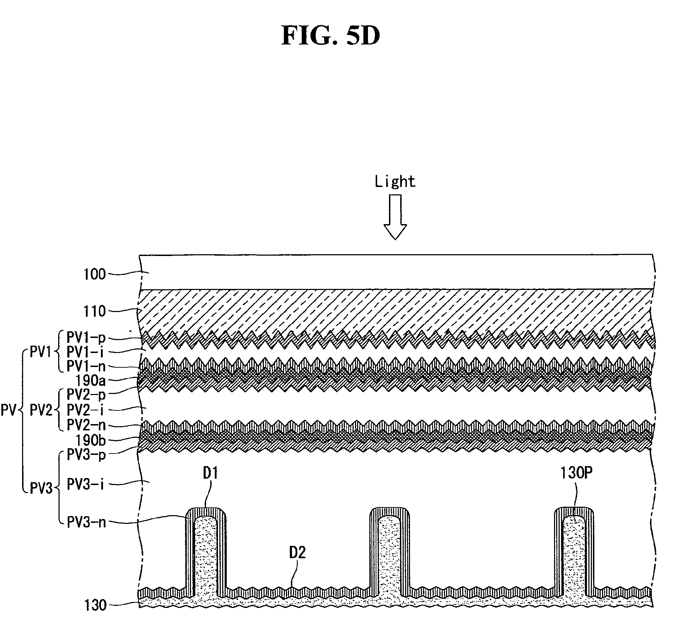

Next, as shown in FIG. 5D, a second electrode 130 is formed on the third n-type semiconductor layer PV3-n.

The second electrode 130 may include a plurality of protrusions 130p protruding to the inside of the first depressions D1 of the third i-type semiconductor layer PV3-i.

Examples of a method for forming the second electrode 130 on the third n-type semiconductor layer PV3-n include a sputtering method and a plating method.

So far, the embodiment of the invention described the thin film solar cell, in which the photoelectric conversion unit contains silicon-based material. However, this is only one instance. For example, the embodiment of the invention may be applied to the thin film solar cell, in which the photoelectric conversion unit contains a material other than the silicon-based material, for example, cadmium telluride (CdTe), copper indium gallium selenide (CIGS), or cadmium sulfide (CdS). Alternatively, the photoelectric conversion unit may contain a material obtained by absorbing dyes molecules, for example, cadmium sulfide (CdS) in porous titanium dioxide (TiO₂). Further, the photoelectric conversion unit may contain an organic material or a polymer material.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A thin film solar cell comprising:
a substrate;
a first electrode positioned on the substrate;
a second electrode which is separated from the first electrode; and
at least one photoelectric conversion unit positioned between the first electrode and the second electrode,
wherein a photoelectric conversion unit positioned farthest from an incident surface of light among the at least one photoelectric conversion unit includes a plurality of first depressions.

2. The thin film solar cell of claim 1, wherein the photoelectric conversion unit positioned farthest from the incident surface of light is positioned closest to the second electrode.

3. The thin film solar cell of claim 2, wherein the plurality of first depressions are formed in a direction proceeding from a surface of the photoelectric conversion unit adjacent to the second electrode and proceeding to the first electrode.

4. The thin film solar cell of claim 1, wherein a depth of each of the plurality of first depressions is about 20 % to 70 % of a thickness of an i-type semiconductor layer of the photoelectric conversion unit closest to the second electrode.

5. The thin film solar cell of claim 1, wherein a depth of each of the plurality of first depressions is about 0.7 µm to 2.5 µm, a distance between the first depressions is about 0.5 mm to 2 mm, and a width of each of the plurality of first depressions is about 20 µm to 200 µm.

6. The thin film solar cell of claim 1, wherein an i-type semiconductor layer of the photoelectric conversion unit closest to the second electrode has an uneven surface including a plurality of second depressions,
wherein a depth of each of the plurality of second depressions is less than a depth of each of the plurality of first depressions.

7. The thin film solar cell of claim 6, wherein a width of each of the plurality of second depressions is less than a width of each of the plurality of first depressions, and a tilt angle of each of the plurality of second depressions is less than a tilt angle of each of the plurality of first depressions.

8. The thin film solar cell of claim 6, wherein the plurality of second depressions are formed in a direction proceeding from a surface of the photoelectric conversion unit adjacent to the second electrode and proceeding to the first electrode,
wherein the plurality of second depressions are positioned between the plurality of first depressions and the plurality of second depressions are not formed on inner surfaces of the plurality of first depressions..

9. The thin film solar cell of claim 1, wherein the photoelectric conversion unit closest to the second electrode includes a p-type semiconductor layer, an i-type semiconductor layer, and an n-type semiconductor layer which are sequentially stacked in a direction proceeding from the first electrode to the second electrode in the order named,
wherein the n-type semiconductor layer of the photoelectric conversion unit closest to the second electrode is positioned on inner surfaces of the first depressions of the i-type semiconductor layer of the photoelectric conversion unit closest to the second electrode and on a surface of the i-type semiconductor layer between the first depressions.

10. The thin film solar cell of claim 9, wherein a thickness of the n-type semiconductor layer positioned on the inner surfaces of the first depressions is substantially equal to a thickness of the n-type semiconductor layer positioned on the surface of the i-type semiconductor layer between the first depressions.

11. The thin film solar cell of claim 1, wherein the second electrode includes a plurality of protrusions protruding to the inside of the first depressions.

12. The thin film solar cell of claim 11, wherein a thickness of the second electrode positioned on the surface of the i-type semiconductor layer between the first depressions is less than a width of each of the plurality of protrusions.

13. The thin film solar cell of claim 1, wherein the at least one photoelectric conversion unit includes a first photoelectric conversion unit and a second photoelectric conversion unit which are sequentially positioned on the first electrode,
wherein an i-type semiconductor layer of the second photoelectric conversion unit includes the plurality of first depressions.

14. The thin film solar cell of claim 1, wherein the at least one photoelectric conversion unit includes a first photoelectric conversion unit, a second photoelectric conversion unit, and a third photoelectric conversion unit which are sequentially positioned on the first electrode,
wherein an i-type semiconductor layer of the third photoelectric conversion unit includes the plurality of first depressions.

15. The thin film solar cell of claim 1, wherein the at least one photoelectric conversion unit includes an i-type semiconductor layer, and the i-type semiconductor layer is formed of microcrystalline silicon.
